# EUROPEAN PATENT SPECIFICATION

(11) **EP 2 559 134 B1**
(45) Date of publication and mention of the grant of the patent: **01.01.2020**
(21) Application number: 11769133.7
(22) Date of filing: 18.04.2011
(51) Int. Cl.: G01R 19/25, G06F 1/26

(54) **VOLTAGE MANAGEMENT METHOD AND SYSTEM FOR PERFORMING ANALOG-TO-DIGITAL CONVERSIONS**
SPANNUNGSVERWALTUNGSVERFAHREN UND -SYSTEM ZUR DURCHFÜHRUNG VON ANALOG-ZU-DIGITAL-UMWANDLUNGEN
PROCÉDÉS ET SYSTÈMES DE GESTION DE TENSION ÉLECTRIQUE POUR EXÉCUTION DE CONVERSIONS ANALOGIQUE-NUMÉRIQUE

(30) Priority: 21.06.2010 US 819617; 16.04.2010 US 324920 P
(43) Date of publication of application: 20.02.2013
(73) Proprietor: LG Chem, Ltd., Seoul 07336 (KR)
(72) Inventor: SISCO, Daniel, West Bloomfield, Michigan 48322 (US)
(74) Representative: Plasseraud IP
(86) International application number: PCT/KR2011/002745
(87) International publication number: WO 2011/129667

(56) References cited:
- US-A- 5 168 276
- US-A- 5 606 242
- US-A- 6 081 098
- US-A- 6 153 950
- US-A1- 2005 040 978
- US-A1- 2006 038 572
- US-B2- 6 744 389

## Description

### [Technical Field]

The present application relates to systems and methods for performing analog-todigital conversions.

### [Background Art]

### CROSS-REFERENCE TO RELATED APPLICATIONS

Battery systems sample, convert, and/or store analog voltages associated with a battery system or a battery cell. Typically, individual algorithms are provided to sample, convert, and store each sampled voltage. However, replication of common algorithms for sampling voltages increases code-base size, and provides a lack of maintainability. Accordingly, it is desirable to provide improved methods and systems that manage the voltage information.

US 5 168 276 A relates to an A/D converter system having automatic, programmable A/D conversion sequences.

### [Disclosure]

The present invention is as defined by the features of claim 1.

A voltage management system in accordance with an exemplary embodiment is provided. The system is as defined in claim 1 and includes a conversion configuration table that stores configuration information associated with a plurality of voltage signals, where the configuration information is associated with an analog-to-digital conversion process. The system further includes a voltage information management module that manages the analog-to-digital conversion of the plurality of voltage signals based on the conversion configuration table to obtain digital voltage values indicative of voltage levels of the plurality of voltage signals. The system further includes a processor configured to communicate with the voltage information management module to process and store the digital voltage values in a memory device.

These and other advantages and features will become more apparent from the following description taken in conjunction with the drawings.

### [Description of Drawings]

FIG. 1 is a functional block diagram illustrating a battery system that includes a voltage management system in accordance with an exemplary embodiment.
FIG. 2 is a flowchart illustrating a voltage management method in accordance with another exemplary embodiment.

### [Best Mode]

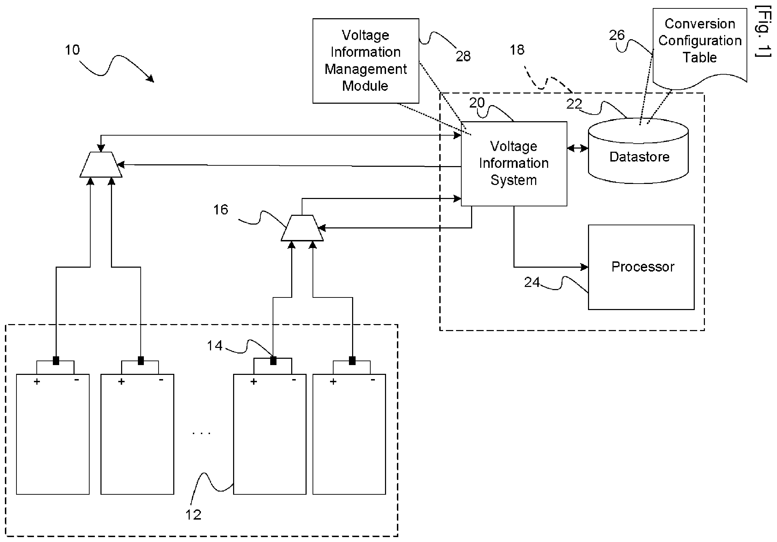

Referring now to the FIG. 1, a battery system that includes a voltage management system is shown generally at 10. As can be appreciated, the voltage management systems and methods of the present disclosure can be applicable to various systems and is not limited to the present example battery system 10.

For the purposes of this disclosure, the exemplary battery system 10 includes one or more battery cells 12. One or more sensors 14 sense one or more conditions of the battery system 10 and generate sensors signals based thereon. For example, a voltage sensor may sense a voltage of the battery cell and may generate a voltage signal based thereon. In various embodiments, the sensors 14 can sense conditions and generate signals corresponding to, for example, supply voltages, hardware feedback voltages, voltages corresponding to battery pack temperatures, voltages corresponding to battery pack current flow, and/or a total battery system voltage. The sensor signals include analog signals.

In various embodiments, one or more multiplexors 16 route the signals from the sensors to a controller 18. The controller 18 can include, but is not limited to, a voltage information system 20, one or more datastores or memory devices 22, and a processor 24. In one exemplary embodiment, the processor 24 is a microprocessor.

In an exemplary embodiment, the voltage information system 20 can include an analog-to-digital converter (ADC). For example, the ADC can be a serial peripheral interface (SPI) based ADC. As can be appreciated, the ADC can be implemented as another piece of ADC hardware, such as one internal to a microcontroller, or to an I2C device.

The voltage information system 20 of the controller 18 manages the voltage information obtained from the analog signals. In particular, the voltage information system 20 manages the voltage information based on a table 26 stored in, for example, the datastore 22. The table 26 includes configuration information relating to the analog-to-digital conversions. In various embodiments, the table 26 can be implemented as an array of data structures. The array length can be determined based on the number of voltages to be converted.

In various embodiments, each data structure can include a plurality of data values. Exemplary data values of the table 26 can include, but are not limited to, a multiplexor select value, a multiplexor input value, a scaling numerator value, a scaling denominator value, and a converted voltage destination address. Definitions of the exemplary data values of the table 26 are provided in Table 1 shown below. In various embodiments, the table 26 content can be predefined, configurable, or a combination thereof.

**Table 1**

| **Structure** | **Values** | **Type** | **Description** |
|---|---|---|---|
| analog-to-digital conversion structure | Multiplexor Select Value | uint8_t | example: select one multiplexor from a set of multiplexors |
| | Multiplexor Input Value | uint8_t | example: select one input to the selected multiplexor. |
| | Scaling numerator value | uint32_t | part of the scaling for this value (gain numerator) |
| | Scaling denominator value | uint32_t | part of the scaling for this value (gain denominator) |
| | Converted Voltage Destination Address | void * | a pointer to the destination of the ADC conversion. This is where the mechanism packs the converted ADC values. |

The multiplexor select value indicates a multiplexor that will be utilized to sample a voltage signal of a plurality of voltage signals. The multiplexor input value indicates an input port of the multiplexor for sampling the voltage signal. The scaling denominator value and a scaling numerator value are utilized to scale the sampled voltage signal to obtain a digital voltage value representing the sampled voltage signal. For example, the sampled voltage signal can be multiplied by a ratio of the scaling numerator value and the scaling denominator value to obtain the digital voltage value.

The converted voltage destination address indicates a storage address in a memory device, such as datastore 22, for storing the digital voltage value. In one exemplary embodiment, the digital voltage value is a binary value indicating an amplitude of the sampled voltage signal.

The voltage information system 20 further includes a voltage information management module 28. As can be appreciated, the voltage information management module 28 can be implemented as software, hardware, firmware, or a combination thereof.

In various embodiments, the voltage information management module 28 is stored in a datastore, such as the datastore 22 for example, that is a computer readable medium. The voltage information management module 28 includes one or more software instructions that, when executed by the processor 24, facilitates the analog-to-digital conversion for each of the voltage signals using the table 26 from the datastore and processes the resulting ADC value.

As described in more detail below, an index is passed to or is managed by the voltage information management module 28. Using the index, the voltage information management module 28 accesses the data structures of the table 26 and extracts information to be used with a series of functions that perform one or more segments of the analog-to-digital conversion process. Based on the analog-to-digital conversion process, the voltage information management module 28 generates and stores a scaled and converted digital voltage value. The digital voltage value represents an amplitude of the voltage that is packed into the appropriate software variable and stored at a specified address in a datastore such as the memory device 24 for example.

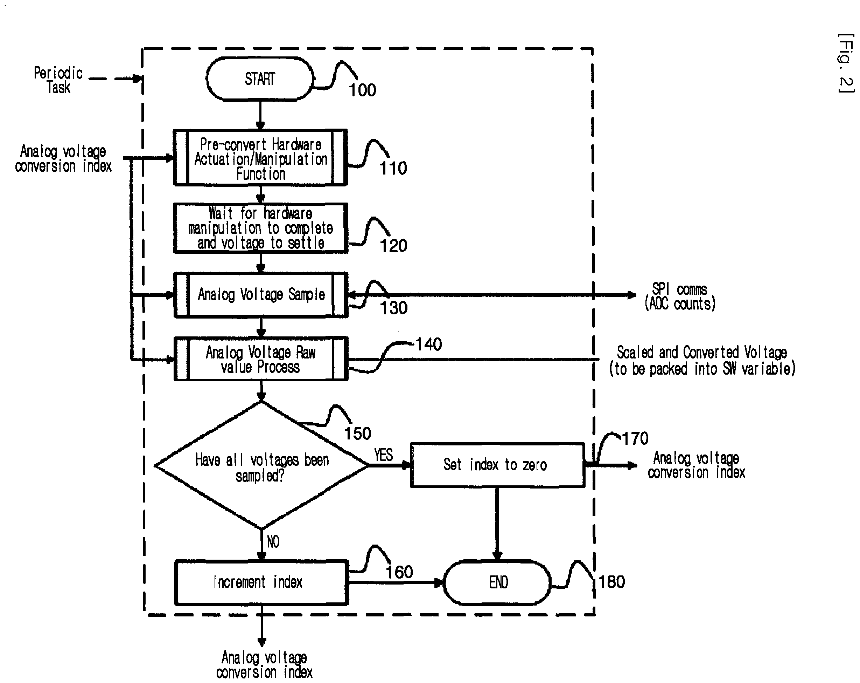

With reference now to FIG. 2, a flowchart illustrates a voltage management method that may be performed by the voltage information management module in accordance with various aspects of the present disclosure. As can be appreciated in light of the disclosure, the order of operation within the method is not limited to the sequential execution as illustrated in FIG. 2, but may be performed in one or more varying orders as applicable and in accordance with the present disclosure. As can be appreciated, one or more steps may be modified, removed from, or added to method.

The method essentially iterates through the table 26 either periodically or nonperiodically and uses the data stored in each data structure to execute a generic ADC conversion process wherein an analog signal received from a specific multiplexor, and a specific multiplexor input, are scaled based on a scaling numerator and a scaling denominator, and are stored at a converted voltage destination address in the datastore 22 for example. In other words, data in the table 26 indicates how to configure the hardware to perform this conversion, where to place the data gathered from the conversion, and is expandable to include additional information like scaling information for example.

The method loops through the elements of table 26, starting again at the first element when all table data has been processed. The method may run indefinitely, and may be started or halted at certain points in the application, or when certain external conditions are true. Assuming a periodic execution time of one second, and assuming there are ten analog voltages to convert, the method would iterate through all voltages and render a complete set of analog voltages converted and packed into software variables in approximately ten seconds.

In one example, as shown in FIG. 2, the method may begin at step 100. A pre-convert hardware actuation/manipulation function is performed at step 110. This function performs any hardware specific actions required for the analog-to-digital conversion. In the above example, a multiplexor and a multiplexor input are selected. The function could also toggle I/O pins, send messages to other modules, etc.

Typically this step performs the same actions with minor or trivial differences for each unique voltage. In the example above, selecting the multiplexor drives an I/O pin based on the structure element multiplexor select.

A wait for hardware manipulation to complete and voltage to settle function is performed at step 120. This is a configurable time that could be added to the control structure if it needs to be unique per conversion, or could be a single global value if common across all conversions.

A sample analog voltage function is performed at step 130. This is the actual analog voltage sample, and like the pre-convert hardware actuation/manipulation function, it can be executed in a similar fashion for all voltages. Any unique requirements per voltage can be captured in the data structure. The converted value is placed in a generic storage buffer.

A process analog voltage raw value function is performed at step 140. This function removes a value from the generic storage buffer in a memory device representing the sampled signal, converts the value using the scaling numerator value and the scaling denominator value from the data structure to obtain the digital voltage value, and then stores the digital voltage value at a destination address in a memory device specified by the converted voltage destination address.

Index management is performed at steps 150 through 170. For example, if all of the voltages have not been sampled at step 150, the index is incremented at step 160 and the method may end at step 180. If, however, all of the voltages have been sampled at step 150, the method continues with resetting the index to, for example, zero at step 170 and the method may end at step 180.

The voltage management system described herein provides a substantial advantage over other systems. In particular, the system utilizes a conversion configuration table that indicates a voltage signal sampling multiplexor, a multiplexor input port, scaling values, and a destination address for storing a digital voltage value, which allows for effectively performing analog-to-digital conversations in a more efficient manner with less duplication of software algorithms.

While the disclosure has been provided in detail in connection with only a limited number of embodiments, it should be readily understood that the invention is not limited to such disclosed embodiments. Accordingly, the invention is not to be seen as limited by the foregoing description.

## Claims

1. A voltage management system (10), comprising:
a conversion configuration table (26) that stores configuration information associated with a plurality of voltage signals, where the configuration information is associated with an analog-to-digital conversion process;
a voltage information management module (28) configured to manage the analog-to-digital conversion of the plurality of voltage signals based on the conversion configuration table to obtain digital voltage values indicative of voltage levels of the plurality of voltage signals; and
a processor (24) configured to communicate with the voltage information management module (28) to process and store the digital voltage values in a memory device (22),
wherein the conversion configuration table includes a multiplexor select value indicating a multiplexor (16) to be utilized to sample respective voltage signal of the plurality of voltage signals, a multiplexor input value indicating an input port of the multiplexor (16) for sampling the respective voltage signal, a scaling denominator value and a scaling numerator value for scaling the respective sampled voltage signal by a ratio of said scaling numerator value and said scaling denominator value to obtain a respective digital voltage value representing the respective sampled voltage signal, and a destination address which indicates a storage address in the memory device (22) for storing the respective digital voltage value.

## Patentansprüche

1. Spannungs-Verwaltungssystem (10), umfassend:
eine Konversions-Konfigurationstabelle (26), welche Konfigurationsinformationen speichert, welche einer Mehrzahl von Spannungssignalen zugeordnet sind, wobei die Konfigurationsinformationen einem analog-zu-digital-Konversionsprozess zugeordnet sind;
ein Spannungsinformation-Verwaltungsmodul (28), welches dazu eingerichtet ist, die analog-zu-digital-Konversion der Mehrzahl von Spannungssignale auf Grundlage der Konversions-Konfigurationstabelle zu verwalten, um digitale Spannungswerte zu erhalten, welche Spannungspegel der Mehrzahl von Spannungssignalen anzeigen; und
einen Prozessor (24), welcher dazu eingerichtet ist, mit dem Spannungsinformations-Verwaltungsmodul (28) zu kommunizieren, um die digitalen Spannungswerte zu verarbeiten und in einer Speichervorrichtung (22) zu speichern,
wobei die Konversions-Konfigurationstabelle einen Multiplexer-Auswahlwert umfasst, welcher einen Multiplexer (16) anzeigt, welcher dazu zu verwenden ist, ein entsprechendes Spannungssignal aus der Mehrzahl von Spannungssignalen, einen Multiplexer-Eingabewert, welcher einen Eingabeanschluss des Multiplexers (16) zum Samplen des entsprechenden Spannungssignals anzeigt, einen Skalierungs-Nennerwert und einen Skalierungs-Zählerwert zum Skalieren des entsprechenden gesampelten Spannungssignals mit einem Verhältnis des Skalierungs-Zählerwerts und des Skalierungs-Nennerwerts, um einen entsprechenden digitalen Spannungswert zu erhalten, welcher das entsprechende gesampelte Spannungssignal repräsentiert, und eine Zieladresse zu samplen, welche eine Speicheradresse in der Speichervorrichtung (22) zum Speichern des entsprechenden digitalen Spannungswerts anzeigt.

## Revendications

1. Système de gestion de tension (10), comprenant :
une table de configuration de conversion (26) qui stocke des informations de configuration associées à une pluralité de signaux de tension, où les informations de configuration sont associées à un processus de conversion analogique-numérique ;
un module de gestion d'informations de tension (28) configuré pour gérer la conversion analogique-numérique de la pluralité de signaux de tension sur la base de la table de configuration de conversion pour obtenir des valeurs de tension numérique indiquant des niveaux de tension de la pluralité de signaux de tension ; et
un processeur (24) configuré pour communiquer avec le module de gestion d'informations de tension (28) pour traiter et stocker les valeurs de tension numérique dans un dispositif de mémoire (22),
dans lequel la table de configuration de conversion comprend une valeur de sélection de multiplexeur indiquant un multiplexeur (16) à utiliser pour échantillonner un signal de tension respectif de la pluralité de signaux de tension, une valeur d'entrée de multiplexeur indiquant un port d'entrée du multiplexeur (16) pour échantillonner le signal de tension respectif, une valeur de dénominateur de mise à l'échelle et une valeur de numérateur de mise à l'échelle pour mettre à l'échelle le signal de tension échantillonné respectif par un rapport de ladite valeur de numérateur de mise à l'échelle et de ladite valeur de dénominateur de mise à l'échelle pour obtenir une valeur de tension numérique respective représentant le signal de tension échantillonné respectif, et une adresse de destination qui indique une adresse de stockage dans le dispositif de mémoire (22) pour stocker la valeur de tension numérique respective.
